# EUROPÄISCHE PATENTSCHRIFT

(11) **EP 0 875 063 B1**
(45) Veröffentlichungstag und Bekanntmachung des Hinweises auf die Patenterteilung: **09.06.1999**
(21) Anmeldenummer: 96946073.2
(22) Anmeldetag: 10.12.1996
(51) Int. Cl.: G11C 16/06, H02M 3/07, H01L 27/115

(54) **VORRICHTUNG ZUR SPANNUNGSVERVIELFACHUNG**
VOLTAGE MULTIPLIER
MULTIPLICATEUR DE TENSION

(30) Priorität: 16.01.1996 DE 19601369
(43) Veröffentlichungstag der Anmeldung: 04.11.1998
(73) Patentinhaber: SIEMENS AKTIENGESELLSCHAFT, 80333 München (DE)
(72) Erfinder: LAUTERBACH, Christl, D-85635 Höhenkirchen-Siegertsbrunn (DE); WEBER, Werner, D-80637 München (DE)
(86) Internationale Anmeldenummer: DE9602387
(87) Internationale Veröffentlichungsnummer: WO9726657

(56) Entgegenhaltungen:
- US-A- 5 077 691
- IEEE JOURNAL OF SOLID-STATE CIRCUITS, Bd. 27, Nr. 11, 1.November 1992, Seiten 1540-1545, XP000320440 AKIRA UMEZAWA ET AL: "A 5-V-ONLY OPERATION 0.6-UM FLASH EEPROM WITH ROW DECODER SCHEME IN TRIPLE-WELL STRUCTURE" in der Anmeldung erwähnt

## Beschreibung

Werden nichtflüchtige Speicher, wie zum Beispiel Flash-EEPROMs, durch die Ausnützung des Fowler-Nordheim-Effektes programmiert, bzw. gelöscht, so ergibt sich eine deutliche Reduzierung im Leistungsverbrauch gegenüber dem Schreiben mit heißen Elektronen. Bei der Ausnützung des Fowler-Nordheim-Effektes können Elektronen durch Anlegen einer positiven Hochspannung am Steuergate einer Speicherzelle von einem jeweiligen Draingebiet auf ein jeweiliges Floating-Gate tunneln. Durch das Anlegen einer negativen Hochspannung am Steuergate und einer positiven Spannung am Drain einer Speicherzelle können die Elektronen vom Floating-Gate zurück zum Draingebiet tunneln. Negative Hochspannungen werden mit Hilfe von Spannungspumpen erzeugt, die nach dem Prinzip der kapazitiven Spannungsvervielfachung arbeiten und pro Pumpstufe eine MOS-Diode und einen Kondensator aufweisen. Unter Hochspannung wird in diesem Zusammenhang bereits eine Spannung von beispielsweise 10 Volt bis 30 Volt angesehen.

Eine besonders effektive Vorrichtung zur Erzeugung negativer Hochspannungen ist in A. Umezawa et al, "A 5-V-Only Operation 0,6-µm Flash EEPROM with Row Decoder Scheme in Triple-Well Structure", IEEE Journal of Solid-State Circuits, Vol. 27, No. 11 (1992), beschrieben. Hierbei werden Hochvolt-PMOS-Transistoren eingesetzt. Ein zusätzlicher Boost-Transistor der Pumpstufe erhöht die Leitfahigkeit einer am Ausgang liegenden MOS-Diode und reduziert so den Spannungsabfall an dieser Diode.

Bei Hochvolttransistoren tritt häufig ein erhöhter Substratsteuereffekt auf, weshalb die einzelnen Transistorwannen in der Vorrichtung zur Spannungsvervielfachung getrennt angeschlossen werden. Bei der Erzeugung einer negativen Hochspannung wurden bislang Hochvolt-PMOS-Transistoren verwendet. Hochvolt-PMOS-Transistoren haben jedoch den Nachteil, daß das Aufladen der Hochvolt-n-Wannen auf die negative Hochspannung die Substrat-Wannen-Diode in Vorwärtsrichtung polt und einen Kurzschluß gegenüber dem Substrat erzeugt.

Die der Erfindung zugrundeliegende Aufgabe liegt nun darin, eine Vorrichtung zur Erzeugung einer negativen Hochspannung anzugeben, bei der das Anlegen einer negativen Hochspannung an die einzeln angeschlossenen kanalbildenden Wannen der Hochvolttransistoren möglich ist, ohne daß ein Kurzschluß gegenüber dem Substrat auftritt.

Diese Aufgabe wird erfindungsgemaß durch die Merkmale des Patentanspruchs 1 gelöst. Vorteilhafte Ausgestaltungen ergeben sich aus den Unteransprüchen.

Die Erfindung wird nachfolgend anhand der Zeichnung näher erlautert. Dabei zeigt
- Figur 1: ein Schaltbild einer erfindungsgemäßen Vorrichtung und
- Figur 2: ein Zeitdiagramm der beim Betreiben der erfindungsgemaßen Vorrichtung anzulegenden Taktsignale.

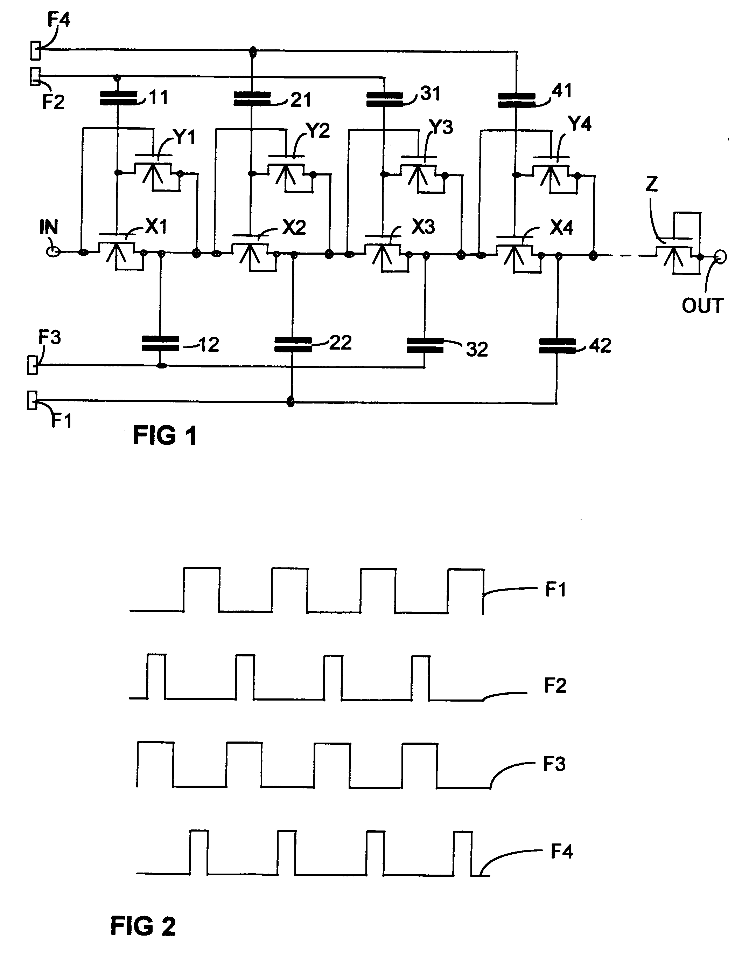

In Figur 1 ist beispielhaft eine vierstufige erfindungsgemaße Vorrichtung zur Erzeugung einer negativen Hochspannung dargestellt, wobei eine erste Stufe einen NMOS-Transistor X1 und einen NMOS-Transistor Y1 sowie einen Kondensator 11 und einen Kondensator 12, eine zweite Stufe NMOS-Transistoren X2, Y2 sowie Kondensatoren 21, 22, eine dritte Stufe NMOS-Transistoren X3, Y3 sowie Kondensatoren 31, 32 und eine vierte Stufe NMOS-Transistoren X4, Y4 sowie Kondensatoren 41 und 42 aufweist. Ein Eingang IN der erfindungsgemaßen Vorrichtung ist mit einem Anschluß des Transistors X1 und mit einem Gateanschluß des Transistors Y1 verbunden und stellt den Eingang der ersten Stufe dar. Das Gate des Transistors X1 ist mit einem Anschluß des Transistors Y1 und über den Kondensator 11 mit einem Takteingang F2 verbunden. Ein Ausgang der ersten Stufe ist mit einem zweiten Anschluß des Transistors Y1 und einem zweiten Anschluß des Transistors X1 sowie über den Kondensator 12 mit einem Taktsignaleingang F3 verbunden. Ein Eingang der zweiten Stufe ist mit dem Ausgang der ersten Stufe verbunden und der Ausgang der zweiten Stufe ist mit dem Eingang der dritten Stufe verbunden. Der Aufbau der zweiten Stufe entspricht dem Aufbau der ersten Stufe, wobei allerdings der Kondensator 21 nicht wie der Kondensator 11 mit dem Taktsignaleingang F2, sondern mit dem Taktsignaleingang F4 und der Kondensator 22 nicht wie der Kondensator 12 mit dem Taktsignaleingang F3, sondern mit dem Taktsignaleingang F1 verbunden ist. Die Stufen 3 und 4 entsprechen in ihrem Aufbau und in ihrer Versorgung mit den Taktsignalen den ersten beiden Stufen und sind der zweiten Stufe nachgeschaltet. Am Ausgang der vierten Stufe ist ein NMOS-Transistor Z vorgesehen, dessen erster Anschluß mit dem Ausgang der vierten Stufe und dessen Gateanschluß und zweiter Anschluß mit dem Ausgangsanschluß OUT der erfindungsgemaßen Vorrichtung, der die Hochspannung führt, verbunden ist. Der Transistor Z wirkt dabei als eine in Durchflußrichtung geschaltete Diode.

Bei den Hochvolt-NMOS-Transistoren X1, Y1 ... X4, Y4 handelt es sich um sogenannte Triple-Well-Transistoren, wie sie beispielsweise in der obengenannten Veröffentlichung von Umezawa in Figur 3a beim NMOS-Transistor des Rowdecoders gezeigt sind. Wie hier in Figur 1 gezeigt, ist dabei die p-Wanne eines jeweiligen NMOS-Transistors mit einem zweiten Anschluß des jeweiligen NMOS-Transistors verbunden. Die äußere, gemeinsamen n-Wanne der NMOS-Transistoren liegt dabei auf 0 Volt. Ein Diodenkurzschluß tritt in dieser Vorrichtung also nicht auf.

Die Transistoren X1 ... X4 wirken als Pumptransistoren zum Aufladen der Kapazitaten und die Transistoren Y1 ... Y4 als sogenannte Boost-Transistoren zum Anheben des Spannungspegels zwischen Gate und Drain des jeweiligen Pumptransistors zur Erhöhung der Leitfähigkeit bzw. der Effizienz. Die Diode Z dient als Abschlußdiode. Die Abschlußdiode verhindert den Potentialausgleich zwischen dem Ausgang OUT und dem Ausgang einer letzten Stufe, für den Fall, daß dieser ein höheres Potential führt als der Aussgang OUT. Führt der Ausgang OUT ein niedrigeres Potential als der Ausgang der letzten Stufe, ist die Abschlußdiode Flußrichtung gepolt und ein Potentialausgleich kann erfolgen.

Durch entsprechendes Hintereinanderschalten von k Stufen kann allgemein eine Hochspannung V_{OUT}=V_{IN} - (k*(F-Vₓ)) erzeugt werden, wobei Vout die Spannung am Ausgang OUT, Vin die Spannung am Eingang IN, k die Anzahl der Stufen, F die Taktspannung und Vₓ der Spannungabfall an einem jeweiligen Pumptransistor X sind. Der Spannungabfall an einem jeweiligen Pumptransistor X ist dabei durch den Einsatz eines jeweiligen Boosttransistor Y deutlich kleiner als die Schwellenspannung V_{T} des jeweiligen Transistors X.

Beim in Figur 1 gezeigten Beispiel mit einer Stufenzahl von k=4, einer Spannung V_{IN} = 0Volt, einer Taktspannung F= 5Volt beträgt die Ausgangsspannung V_{OUT}= 19,6Volt.

Für k>4 sind ebenfalls nur 4 Taktsignals erforderlich, da die ersten Kapazitäten 11, 21, .. abwechselnd mit den Takteingängen F2 und F4 und die zweiten Kapazitäten abwechselnd mit den Eingängen F1 und F3 verbunden sind.

In Figur 2 sind die zeitlichen Verlaufe der Taktsignale an den Taktsignaleingängen F1 ... F4 untereinander dargestellt. Bei der erfindungsgemäßen Vorrichtung, also bei einer Pumpe für negative Hochspannungen mit positiven Eingangstakten, findet der Pumpzyklus immer dann statt, wenn die Pumptakte F1 und F3 logisch low sind, während der Boostzyklus bei logisch high von F2 und F4 stattfindet und wesentlich kurzer sein kann als der Pumpzyklus. Die Signale der Eingänge F1 und F3 bzw. die Signale der Eingänge F2 und F4 sind jeweils um etwa die halbe Taktzeit zeitlich gegeneinander verschoben. Das zeitliche Überlappen der Taktsignale an den Eingängen F1 und F3 sorgt für eine Vorladung der Pumptransistoren X1 ... X4. Die Taktsignale an den Eingängen F2 und F4 sind zeitlich so gesetzt, daß während der Durchlaßphase des jeweiligen Pumptransistors der jeweilige Boost-Transistor sperrt und eine erhöhte Spannung zwischen dem Gate und dem Drain des jeweiligen Pumptransistors anliegt, wodurch seine Leitfähigkeit erhöht wird.

## Patentansprüche

1. Vorrichtung zur Erzeugung einer negativen Hochspannung,
- bei der mindestens vier Pumptransistoren (X1..X4) als Reihenschaltung beschaltet sind, wobei ein erster Pumptransistor (X1) direkt mit einem Eingang (IN) und ein letzter Pumptransistor (X4) direkt oder indirekt mit einem Ausgang (OUT) der Vorrichtung verbunden sind,
- bei der die Gates der ungeradzahligen Pumptransistoren (X1,X3) über erste Kapazitäten (11,31) mit einem ersten Taktsignaleingang (F2) und die der geradzahligen Pumptransistoren (X2,X4) über weitere erste Kapazitäten (21,41) mit einem zweiten Taktsignaleingang (F4) verbunden sind und
- bei der ungeradzahlige Verbindungsknoten (X1, X2 ; X3,X4) der Reihenschaltung über zweite Kapazitäten (12,32) mit einem dritten Taktsignaleingang (F3) und geradzahlige Verbindungsknoten (X2,X3 ; X4, OUT bzw. X4,Z) der Reihenschaltung über weitere zweite Kapazitäten (22,42) mit einem vierten Taktsignaleingang (F1) verbunden sind,
- dadurch gekennzeichnet, daß die Pumptransistoren (X1..X4) aus Hochvolt-NMOS-Transistoren bestehen, deren jeweilige kanalbildende Wanne mit einem jeweiligen Verbindungsknoten der Reihenschaltung verbunden ist.

2. Vorrichtung nach Anspruch 1,
- bei der das Gate eines jeweiligen Pumptransistors über einen jeweiligen Boost-Transistor (Y1..Y4) mit dem jeweiligen Verbindungsknoten zum nächsten Pumptransistor und das Gate des jeweiligen Boost-Transistors mit dem jeweiligen Verbindungsknoten zum vorhergehenden Pumptransistor oder dem Eingang (IN) der Vorrichtung verbunden sind und
- bei der alle Boost-Transistoren aus Hochvolt-NMOS-Transistoren bestehen, deren jeweilige kanalbildende Wanne mit einem jeweiligen Verbindungsknoten der Reihenschaltung verbunden ist.

3. Vorrichtung nach Anspruch 1 oder 2,
- bei der der letzter Pumptransistor (X4) indirekt über eine Abschlußdiode(Z) mit dem Ausgang (OUT) der Vorrichtung verbunden ist und
- bei der die Abschlußdiode aus einem Hochvolt-NMOS-Transistor (Z) besteht, dessen kanalbildende Wanne mit dem Ausgang der Vorrichtung verbunden ist.

## Claims

1. Device for generating a negative high voltage,
- in which at least four pumping transistors (X1..X4) are connected as a series circuit, a first pumping transistor (X1) being connected directly to an input (IN) and a last pumping transistor (X4) being connected directly or indirectly to an output (OUT) of the device,
- in which the gates of the odd-numbered pumping transistors (X1,X3) are connected via first capacitors (11,31) to a first clock signal input (F2) and those of the even-numbered pumping transistors (X2,X4) are connected via further first capacitors (21,41) to a second clock signal input (F4) and
- in which odd-numbered connection nodes (X1,X2 ; X3,X4) of the series circuit are connected via second capacitors (12,32) to a third clock signal input (F3) and even-numbered connection nodes (X2,X3 ; X4,OUT or X4,Z) of the series circuit are connected via further second capacitors (22,42) to a fourth clock signal input (F1),
- characterized in that the pumping transistors (X1..X4) comprise high-voltage NMOS transistors whose respective channel-forming well is connected to a respective connection node of the series circuit.

2. Device according to Claim 1,
- in which the gate of a respective pumping transistor is connected via a respective boost transistor (Y1..Y4) to the respective connection node to the next pumping transistor and the gate of the respective boost transistor is connected to the respective connection node to the preceding pumping transistor or to the input (IN) of the device, and
- in which all of the boost transistors comprise high-voltage NMOS transistors whose respective channel-forming well is connected to a respective connection node of the series circuit.

3. Device according to Claim 1 or 2,
- in which the last pumping transistor (X4) is connected indirectly via a terminating diode (Z) to the output (OUT) of the device, and
- in which the terminating diode comprises a high-voltage NMOS transistor (Z) whose channel-forming well is connected to the output of the device.

## Revendications

1. Dispositif pour produire une haute tension négative,
- dans lequel au moins quatre transistors de pompage (X1 ... X4) sont branchés en tant que montage en série, un premier transistor de pompage (X1) étant relié directement à une entrée (IN) et un dernier transistor de pompage (X4) étant relié, directement ou indirectement, à une sortie (OUT) du dispositif,
- dans lequel les grilles des transistors de pompage impairs (X1, X3) sont reliées à une première entrée de signaux de synchronisation (F2) par le biais de premiers condensateurs (11, 31) et celles des transistors de pompage pairs (X2, X4) sont reliées à une deuxième entrée de signaux de synchronisation (F4) par le biais de premiers condensateurs supplémentaires (21, 41) et
- dans lequel les noeuds de jonction impairs (X1,X2 ; X3,X4) du montage en série sont reliés à une troisième entrée de signaux de synchronisation (F3) par le biais de seconds condensateurs (12, 32) et les noeuds de jonction pairs (X2,X3 ; X4, OUT resp. X4,Z) du montage en série sont reliés à une quatrième entrée de signaux de synchronisation (F1) par le biais de seconds condensateurs supplémentaires (22, 42),
- caractérisé en ce que les transistors de pompage (X1 ... X4) sont formés par des transistors NMOS pour tensions élevées dont la cuve respective formant un canal est reliée à un noeud de jonction respectif du montage en série.

2. Dispositif selon la revendication 1,
- dans lequel la grille d'un transistor de pompage respectif est reliée, par le biais d'un transistor amplificateur respectif (Y1 ... Y4), au noeud respectif de jonction avec le transistor de pompage suivant et la grille du transistor amplificateur respectif est reliée au noeud respectif de jonction avec le transistor de pompage précédent ou à l'entrée (IN) du dispositif, et
- dans lequel tous les transistors amplificateurs sont formés par des transistors NMOS pour tensions élevées dont la cuve respective formant un canal est reliée à un noeud de jonction respectif du montage en série.

3. Dispositif selon l'une des revendications 1 ou 2,
- dans lequel le dernier transistor de pompage (X4) est relié indirectement à la sortie (OUT) du dispositif par le biais d'une diode terminale (Z) et
- dans lequel la diode terminale est formée par un transistor NMOS pour tensions élevées (Z) dont la cuve formant un canal est reliée à la sortie du dispositif.
